# EUROPEAN PATENT APPLICATION

(11) **EP 2 684 983 A2**
(43) Date of publication of application: **15.01.2014**
(21) Application number: 13175500.1
(22) Date of filing: 08.07.2013
(51) Int. Cl.: C25D 5/00, C23C 18/08, C23C 18/14, H01L 31/18, C25D 7/12, C25D 5/10

(54) **Improved method of metal plating semiconductors**

(30) Priority: 09.07.2012 US 201213544223
(71) Applicant: Rohm and Haas Electronic Materials LLC, Marlborough, MA 01752 (US)
(72) Inventor: Wei, Lingyun, Shrewsbury, MA 01545 (US); Hamm, Gary, Billerica, MA 01821 (US); Karaya Jr., Narsmoul, Dorcester, MA 02124 (US)
(74) Representative: Buckley, Guy Julian

(57) **Abstract**

A metal underlayer is selectively plated on semiconductor wafers immediately followed by plating copper on the metal underlayer using a low internal stress copper plating bath. Additional metallization may be done to build up the metal layers using conventional metal plating baths and methods to form current tracks. Formation of metal silicides is avoided. Good adhesion of the metals to the semiconductors is achieved. The metalized semiconductors may be used in the manufacture of photovoltaic devices.

## Description

### Filed of the Invention

The present invention is directed to an improved method of metal plating semiconductors. More specifically, the present invention is directed to an improved method of metal plating semiconductors by eliminating sintering and using low internal stress copper plating solutions to improve metal adhesion to the semiconductors.

### Background of the Invention

Metal plating of doped semiconductors, such as photovoltaic devices and solar cells, involves the formation of electrically conductive contacts on front and back sides of the semiconductors. The metal coating must be able to establish ohmic contact with the semiconductor in order to ensure that charge carriers emerge from the semiconductor into the electrically conductive contacts without interference. In order to avoid current loss, metallized contact grids must have adequate current conductivities or a sufficiently high conductor track cross section.

Numerous processes which meet the above requirements exist for metal coating the back sides of solar cells. For example, in order to improve current conduction at the back side of solar cells, p-doping directly under the back side is reinforced. Usually aluminum is used for this purpose. The aluminum is applied, for example, by vapor deposition or by being printed onto the back side and being driven in or, respectively, alloyed in. When metal coating the front sides, or light incidence sides, the objective is to achieve the least amount of shading of the active semiconductor surface in order to use as much of the surface as possible for capturing photons.

Processes for producing the front side contacts make use of laser or photographic techniques for the definition of the current track structures. The current tracks are then metalized. In general, various metal coating steps are used in order to apply the metal coating in attempting to achieve sufficient adhesive strength and a desired thickness for electrical conductivity. Copper is a highly desirable metal for forming current tracks on silicon in the manufacture of photovoltaic devices such as solar cells. The copper may be coated with a fine layer of tin or silver to protect it from oxidation. However, copper plated directly on the silicon surface may diffuse into the silicon and disrupt electrical conductivity or poison the photovoltaic device. In addition, direct plating of copper to the silicon does not always result in adequate adhesion between the copper and the silicon. To address these problems nickel is often plated adjacent the silicon surface of the conductor tracks and functions as an underlayer or barrier layer to inhibit copper diffusion into the silicon. In order to achieve acceptable adhesion of the metal layers to the silicon, a nickel silicide is formed prior to copper plating. However, sintering temperatures used during formation of nickel silicide can result in diffusion of nickel through the emitter and shunting of the device.

Significant power loss may be caused by the presence of a low shunt resistance, Rₛₕ. A low shunt resistance causes power losses in photovoltaic devices by providing an alternate current path for light-generated current. Such a diversion reduces the amount of current flowing through the photovoltaic device junction and reduces voltage from the device. The effect of a shunt resistance is particularly severe at low light levels, since there is less light-generated current. The loss of this current to the shunt therefore has a larger impact. In addition, at low voltages where the effective resistance of the device is high, the impact of the resistance in parallel is large.

Another problem associated with sintering is reactivating the metal of the silicide such that copper may be plated. Reactivating the metal silicide with activation materials, such as dilute hydrofluoric acid, is often unreliable and may result in poor adhesion of copper or other metals plated over the reactivated nickel/nickel silicide layer. In addition, reactivation with dilute hydrofluoric acid involves additional steps and attacks the antireflective layer.

Another approach to improving adhesion of metal to silicon is the formation of a thin nanoporous layer in the top surface of the emitter. The nanoporous layer provides tiny pores which enable metal to deposit within the pores and on the surface of the silicon to form a mechanical bond to secure the metal to the silicon surface. Such nanopores may be formed by using various etching methods, such as anodic etching. Disadvantages to this process include additional time-consuming steps and additional equipment. Another disadvantage is that the depth to which the nanoproes are formed in the emitter layer must be carefully controlled. If the nanopores are formed too deep within the emitter layer, electrical performance may be compromised. Nanoporous silicon processing may also significantly attack silicon nitride and silicon oxide antireflective coatings leading to an increase in undesired background plating which can impact light transmission and significantly reduce photovoltaic and solar cell performance.

Another adhesion problem may occur during assembly when joining interconnecting ribbons are attached to individual photovoltaic devices or solar cells in the manufacture of photovoltaic modules. Such ribbons are typically composed of a copper core coated with tin or tin alloy and one or more additional metals. The ribbon is typically joined to a bus bar of the photovoltaic device by soldering at a temperature of greater than 250° C to 400° C. The ribbons allow multiple photovoltaic devices or solar cells to be joined together in series and then encapsulated in a dielectric material to form modules. Adhesion failure of one of the interconnecting ribbons in the module leads to an electrical open or short and failure of the entire module.

Accordingly, there is a need for an improved method of plating copper on semiconductor wafers in the formation of front side current tracks which provides good adhesion and reduces the number of process steps to provide for a more efficient metallization method.

### Summary of the Invention

Methods include providing a semiconductor including a front side, a back side, and a pn-junction, the front side includes a pattern of conductive tracks and a bus bar, the conductive tracks and the bus bar include an underlayer and the back side includes metal contacts; contacting the semiconductor with a low internal stress copper plating composition; and plating a low internal stress copper layer adjacent the underlayer of the conductive tracks and bus bar.

The methods eliminate sintering of metals to form silicides, thus reducing or eliminating shunting. Also the need for reactivation of the metal underlayer prior to low internal stress copper plating is avoided, as the copper can be plated immediately following underlayer deposition. The overall number of metallization steps is reduced, thus making metallization of semiconductors more efficient and less costly than many conventional processes. Attachment of interconnect ribbons to bus bars on photovoltaic devices is done at lower temperatures than is typically done in conventional module assembly and may also be done using low temperature adhesives as opposed to soldering.

### Detailed Description of the Invention

As used throughout this specification, the terms "depositing" and "plating" are used interchangeably. The terms "current tracks" and "conductive tracks" are used interchangeably. The terms "composition", "solution" and "bath" are used interchangeably. The indefinite articles "a" and "an" are intended to include both the singular and the plural. The term "selectively depositing" means that metal deposition occurs in specific desired areas on a substrate. The term "lux = lx" is a unit of illumination equal to one lumen/m²; and one lux = 1.46 milliwatt of radiant electromagnetic (EM) power at a frequency of 540 tetrahertz.

The following abbreviations have the following meanings unless the context clearly indicates otherwise: °C = degrees Celsius; g = grams; mg = milligrams; ppm = part per million; ppb = parts per billion; mL = milliliter; L = liter; A = amperes; dm = decimeter; cm = centimeter; 2.54 cm = 1 inch; mm = millimeters; µm = micrometers; nm = nanometers; psi = pounds per square inch = 0.00689 MPa; MPa = megapascal; LIP = light induced plating; LED = light emitting diode; V = volts; UV = ultra-violet; IR = infrared; and N = Newtons.

All percentages and ratios are by weight unless otherwise indicated. All ranges are inclusive and combinable in any order except where it is clear that such numerical ranges are constrained to add up to 100%.

Semiconductors may be composed of monocrystalline or polycrystalline silicon. Such semiconductors are typically used in the manufacture of photovoltaic devices and solar cells. Silicon wafers typically have a p-type base doping.

The back side of a wafer is metalized to provide a rear contact. Any conventional method may be used. The entire back side may be metal coated or a portion of the back side may be metal coated, such as to form a grid. Bus bars are typically included on the back side of the wafer. Such back side metallization may be provided by a variety of techniques. In one embodiment, a metal coating is applied to the back side in the form of an electrically conductive paste, such as a silver-containing paste, an aluminum-containing paste or a silver and aluminum-containing paste; however, other pastes which include metals such as nickel or copper also may be used. Such conductive pastes typically include conductive particles embedded in a glass matrix and an organic binder. Conductive pastes may be applied to the wafer by a variety of techniques, such as screen printing. After the paste is applied, it is fired to remove the organic binder. When a conductive paste containing aluminum is used, the aluminum partially diffuses into the back side of the wafer, or if used in a paste also containing silver, may alloy with the silver. Use of such aluminum-containing paste may improve the resistive contact and provide a "p+"-doped region. Heavily doped "p+"-type regions by previous application of aluminum or boron with subsequent interdiffusion may also be produced. Alternatively, a seed layer may be deposited on the back side of the wafer and a metal coating may be deposited on the seed layer by electroless or electrolytic plating.

The front side of the wafer is subjected to crystal-oriented texture etching in order to impart to the surface an improved light incidence geometry which reduces reflections, such as pyramid formation. To produce the semiconductor junction, phosphorus diffusion or ion implantation takes place on the front side of the wafer to produce an n-doped (n+ or n++) region and provides the wafer with a pn-junction. The n-doped region may be referred to as the emitter layer. Preferably, the emitter layer of the wafers is not nanoporous.

An anti-reflective layer is added to the front side or emitter layer of the wafer. In addition the anti-reflective layer may serve as a passivation layer. Suitable anti-reflective layers include, without limitation, silicon oxide layers such as SiOₓ, silicon nitride layers such as Si₃N₄, and a combination of silicon oxide and silicon nitride layers. In the foregoing formula x is the number of oxygen atoms. Such anti-reflective layers may be deposited by a number of techniques, such as by various vapor deposition methods, for example, chemical vapor deposition and physical vapor deposition. A chemical edge isolation step may also be done prior to metallization to ensure no current path exists from emitter to back side.

The front side of the wafer is metallized to form a metallized pattern of current tracks and bus bars. The current tracks are typically transverse to the bus bars and typically have a relatively fine-structure (i.e. dimensions) relative to the bus bars.

Prior to metallization of the front side an opening or pattern is defined. The pattern reaches through the antireflective layer to expose the surface of the semiconductor body of the wafer. A variety of processes may be used to form the pattern, such as, but not limited to, laser ablation, mechanical means, and lithographic processes, all of which are well known in the art. Such mechanical means include sawing and scratching. Pattern widths may range from 10µm to 90µm.

The openings may optionally be contacted with dilute acid, such as hydrofluoric acid, or other chemical solutions, such as a buffered oxide etch solution, to activate the semiconductor surface for metallization. When hydrofluoric acid is used, typically it is a 0.5-2% dilute solution. Activation is preferably done prior to depositing a nickel underlayer.

Prior to metal plating the semiconductor may be edge masked. Edge masking reduces the probability of shunting the semiconductor wafer during metallization due to bridging of metal deposits from the n-type emitter layer to the p-type layer of the semiconductor wafer. Edge masking may be done by applying a conventional plating resist along the edge of the semiconductor wafer prior to metallization. Such plating resists may be a wax based composition which includes one or more waxes, such as montan wax, paraffin wax, soy, vegetable waxes and animal waxes. In addition, such resists may include one or more crosslinking agents, such as conventional acrylates, diacrylates and triacrylates, and one or more curing agents to cure the resist upon exposure to radiation, such as UV and visible light. Curing agents include, but are not limited to, conventional photoinitiators used in photoresists and other photosensitive compositions. Such photoinitiators are well known in the art and published in the literature. Such plating resists may be applied by conventional screen printing procedures or by selective inkjet processes. Alternatively, the semiconductor wafer may be edge masked with the antireflective layer. This may be done by depositing the material used to make the antireflective layer on the edges of the semiconductor layer during formation of the antireflective layer.

While it is envisioned that various metals may be used to form the underlayer, preferably the metals are nickel and cobalt. More preferably the metal is nickel. Such underlayers may be deposited adjacent the surface of the emitter layer by using conventional electroless, electrolytic, LIP, sputtering, chemical vapor deposition and physical vapor deposition methods well known in the art. Preferably the metal underlayer is deposited by electroless, light assisted electroless or LIP. More preferably the metal underlayer is deposited by LIP. Conventional electroless and electrolytic metal plating baths may be used to deposit the metal underlayer. An example of a commercially available nickel bath is ENLIGHT™ 1400 Electrolytic Nickel electroplating solution (available from Rohm and Haas Electronic Materials, LLC, Marlborough, MA). Other examples of suitable electrolytic nickel plating baths are the Watts-type baths disclosed in U.S. 3,041,255.

When the metal underlayer is deposited by LIP, a rear side potential (rectifier) is applied to the semiconductor wafer substrate. Typical current densities are from 0.1 A/dm² to 2 A/dm², more typically from 0.5 A/dm² to 1.5 A/dm². When LIP is done, the light may be continuous or pulsed. Light which may be used to plate includes, but is not limited to, visible light, infrared, UV and X-rays. Light sources include, but are not limited to, incandescent lamps, LEDs, IR lamps, fluorescent lamps, halogen lamps and lasers. Light intensities may range from 400 lx to 20,000 lx, or such as from 500 lx to 7500 lx. Plating is done until an underlayer of 20nm to 2µm thickness, or such as from 500nm to 1µm thickness is deposited. However, the exact thickness depends on various factors such as type of metal, plated thickness uniformity across wafer surface, semiconductor size, current track pattern and geometry of the semiconductor. Minor experimentation may be done to determine the exact metal layer thickness for a given metal and semiconductor.

In one plating method where nickel is used to form the underlayer, light may applied to the semiconductor at an initial intensity for a predetermined amount of time followed by reducing the initial light intensity to a predetermined amount for the remainder of the plating cycle to deposit the nickel onto the current tracks of the semiconductor. The light intensity applied to the semiconductor following the initial light intensity and applied for the remainder of the plating cycle is always less than the initial intensity. The absolute values of the initial light intensity and the reduced light intensity following the initial period vary and they may be varied during the plating process to achieve optimum plating results as long as the initial light intensity is higher than the light intensity for the remainder of the plating cycle.

After the underlayer is deposited a low internal stress copper layer is immediately plated adjacent to it from a low internal stress copper plating solution. The underlayer is not reactivated nor is it sintered to form a metal silicide, such as a nickel or cobalt silicide, prior to copper plating. Sintering is avoided in the methods because sintering may cause undesired shunting resulting in defects in the final photovoltaic device. Rₛₕ typically is 5000 ohm cm² or greater.

Low internal stress copper layers may be deposited adjacent the underlayer ranging from 11µm to 50µm or such as from 5µm to 25µm. Copper plating may be done by electrolytic plating or by LIP. When plating is done by electrolytic plating, it is typically front contact plating. LIP is typically done by rear contact plating. Current density during copper plating may range from 0.01 A/dm² to 5 A/dm² or such as from 0.5 A/dm² to 2 A/dm². When LIP is used to plate the low internal stress copper, light is applied to the front side of the wafer and a rear side potential (rectifier) is applied to the semiconductor wafer substrate. By illuminating the front of the semiconductor wafer with light energy, plating occurs on the front. The impinging light energy generates a current in the semiconductor. The light may be continuous or pulsed. Light which may be used to plate is described above. In general the amount of light applied to the semiconductor wafer during plating may be from 10,000 lx to 70,000 lx, or such as from 30,000 1x to 50,000 1x.

Internal stress may be measured using conventional methods and apparatus, such as a deposit stress analyzer (available from Specialty Testing and Development Co., Jacobus, PA, www.specialtytest.com). Using this measurement method the stress may be determined using the equation S = U/3TxK, where S is stress in psi, U is number of increments of deflection on the calibrated scale of the analyzer, T is metal deposit thickness in inches and K is the test strip calibration constant which may vary from the type of test strip and is provided with the particular analyzer from the company of origin. Test strips are typically flexible copper/beryllium alloy strips or nickel/iron alloy strips.

Internal stress is the degree to which a plated metal deposit exerts stress on a substrate upon which the metal is plated. Deposit stress may be either tensile or compressive. Tensile stress is indicated by a deflection of the test strip in the direction of the plated deposit. Compressive stress is indicated by a deflection of the strip away from the side on which the metal is plated. Positive stress values are tensile and negative values, i.e., less than zero, indicate compressive stress deposits. A negative deposit stress value indicates compressive deposit stress. Low internal stress of a metal plated deposit is 700 psi or less measured both after plating and after annealing for 10 minutes at 100° C or after allowing the plated test strip to equilibrate at room temperature for 1-2 days. Preferably the internal stress is 250 psi or less. More preferably the internal stress is 250 psi to -300 psi. Anneal or equilibration time is needed to account for any increase in measured stress value which may occur during room temperature anneal of the plated deposit. Room temperature anneal is a room temperature recrystallization process where the grain structure and physical properties of the deposit may change from as-plated condition. Grain size increases over time. As the grain size increases the deposit shrinks. This shrinkage of the deposit increases stress between the plated deposit and silicon and can lead to adhesion failure. Testing is preferably done using the deposit stress analyzer. The lower the psi value the greater the probability of achieving desired adhesion of a metal to a substrate.

Sources of copper ions include, but are not limited to, one or more of copper fluoborate, cupric oxalate, cuprous chloride, cupric chloride, copper sulfate, copper oxide and copper alkane sulfonates. Typically the copper compounds are copper sulfate and copper methane sulfonate. The copper compounds are generally water-soluble and are commercially available or may be prepared by methods known in the literature. Optionally, one or more reducing agents can be included in the low internal stress copper plating solutions to reduce the cupric ions (Cu²⁺) to cuprous ions (Cu⁺) and maintain cuprous ions in the monovalent state. Monovalent copper baths are clear. Copper compounds may be included in the electroplating baths in amounts of 1 g/L to 300 g/L.

Additives may include, but are not limited to accelerators, levelers, suppressors, surfactants, buffering agents, pH adjustors, sources of halide ions, organic and inorganic acids, conductivity salts, chelating agents and complexing agents.

Suppressors include, but are not limited to, polyoxyalkylene glycol, carboxymethylcellulose, nonylphenolpolyglycol ether, octandiolbis-(polyalkylene glycolether), octanolpolyalkylene glycolether, oleic acidpolyglycol ester, polyethylenepropylene glycol, polyethylene glycol, polyethylene glycoldimethylether, polyoxypropylene glycol, polypropylene glycol, polyvinylalcohol, stearic acidpolyglycol ester and stearyl alcoholpolyglycol ether. Typically they are included in the electroplating baths in amounts of 0.1 g/L to 10 g/L, more typically from 1 g/L to 5 g/L.

Accelerators are compounds which in combination with one or more suppressors lead to an increase in plating rate at a given plating potential. The accelerators may be sulfur containing organic compounds. The type of accelerators which may be used, in general, are not limited as long as the accelerator is used at concentrations and at current densities which provide copper deposits with low internal stress. Accelerators include, but are not limited to, ethylenedithiodipropyl sulfonic acid, bis-(ω-sulfobutyl)-disulfide, methyl-ω-sulfopropyl)-disulfide, 3-mercapto-1-propane sulfonic acid, N,N-dimethyldithiocarbamic acid (3-sulfopropyl) ester, (O-ethyldithiocarbonato)-S-(3-sulfopropyl)-ester, 3-[(amino-iminomethyl)-thiol]-1-propanesulfonic acid, 3-(2-benzylthiazolylthio)-1-propanesulfonic acid, and alkali metal salts thereof. In general, when such accelerators are included, they are included in amounts of 1ppm and greater. Preferably such accelerators are included in copper electroplating baths in amounts of 2ppm and greater, more preferably from 3ppm to 500 ppm.

Conventional nonionic, anionic, cationic and amphoteric surfactants may be included in the electroplating baths. Typically the surfactants are nonionic. Examples of nonionic surfactants are alkyl phenoxy polyethoxyethanols, nonionic surfactants which include multiple oxyethylene, such as polyoxyethylene polymers having from as many as 20 to 150 repeating units. Such compounds also may perform as suppressors. Further examples are block copolymers of polyoxyethylene and polyoxypropylene. Typically they are included in the electroplating baths in amounts of 0.05 g/l to 15 g/L.

Halogen ions include chloride, fluoride, and bromide. Such halides are typically added into the bath as a water soluble salt or acid. Chloride is typically used and is introduced into the bath as hydrochloric acid. Halogens may be included in the baths in amounts such as from 20ppm to 500ppm, more typically from 50ppm to 100ppm.

Reducing agents which may be added to the copper plating solutions include, but are not limited to, alkali sulfites, alkali bisulfites, hydroxylamines, hydrazines, boranes, sugars, hydantoin and hydantoin derivatives, formaldehyde and formaldehyde analogs. Such reducing agents may be included in the plating compositions in amounts of 10 g/L to 150 g/L.

Complexing agents include, but are not limited to, imide and imide derivatives and hydantoin and hydantoin derivatives. Imide derivatives include, but are not limited to, succinimide, 3-methyl-3-ethyl succinimide, 1-3 methyl succinimide, 3-ethyl succinimide, 3,3,4,4-teramethyl succinimide, 3,3,4-trimethyl succinimide and maleimide. Hydantoin derivatives include, but are not limited to, 1-methylhydantoin, 1,3-dimethylhydantoin, 5,5-dimethylhydantoin and allantoin. Amounts of complexing agents are included in the plating composition depend on the amount of copper in the composition. Typically the molar ratio of copper to complexing agent is from 1:1 to 1:5. A typical range of complexing agent concentration is from 4 g/L to 300 g/L.

Conductivity salts include, but are not limited to, one or more or sulfates, phosphates, citrates, gluconates and tartrates. Examples of such salts are sodium sulfate, potassium pyrophosphate, sodium phosphate, sodium citrate, sodium gluconate and Rochelle salts, such as potassium sodium tartrate. Such salts may be included in amounts of 5 g/L to 75 g/L.

The pH of the low internal stress copper plating solutions ranges from less than 1 to 12. The pH may be adjusted with conventional organic, inorganic acid or base or alkali salt that is compatible with the low internal stress copper bath.

The copper plating composition may be prepared over a wide temperature range. Typically it is prepared at room temperature. During copper plating the temperature of the copper plating composition may range from 15° C to 70° C, typically 20° C to 45° C.

A final finish layer is plated over the copper deposit to prevent oxidation and preserve solderability. Typically a tin flash layer is deposited adjacent the copper. Tin flash layers may range from 0.25µm to 6µm, typically 1µm to 3µm Conventional tin plating baths may be used to deposit the flash layer adjacent the copper. Tin plating may be done using electrolytic methods including LIP. Current densities may range from 0.1 A/dm² to 3 A/dm². As an alternative to tin a flash layer of tin/lead alloy may be plated. In addition to tin or tin/lead, silver may be plated as the final finish. An example of a commercially available silver plating bath is ENLIGHT™ Silver Plate 620 cyanide-free silver electroplating solution (available from Rohm and Haas Electronic Materials, LLC). Also an organic solubility preservative may be applied to the copper or tin or tin/lead flash layer. Such organic solubility preservative layers are well known in the art.

The metal layers on the semiconductors have improved adhesion over many metalized semiconductors prepared using conventional processes. In general, metal adhesion is sufficient to pass conventional tape tests, such as using Scotch transparent tape Cat.#600 indicating a plated metal bond strength of 1N or greater. Conventional methods and apparatus such as GP Stab Test Pro manufactured by GP Solar GmbH of Konstanz, Germany may be used to measure the bond strength.

No sintering is done after metal plating or any additional steps in the buildup of metal layers to form current tracks. The method is a sintering-free method.

During assembly of individual solar cells to form a photovoltaic module an interconnecting ribbon is bonded to the bus bar. The interconnecting ribbon permits electrical contact from one solar cell to another such that two or more may be joined in electrical series. The series of interconnecting solar cells are assembled into modules enclosed in materials such as ethylene vinyl acetate (EVA), silicones, polyesters, polyurethanes, polyamides and polyolefins.

The interconnecting ribbons are typically copper coated with tin, tin/silver, tin/silver/lead alloys or tin/bismuth alloys. The width of the ribbons may vary. Typically they are 1mm to 2 mm. The ribbons may be joined to the metal layers by inductive soldering or laser soldering, provided they are soldered at temperatures of 200° C or less, preferably from 150° C to 200° C to provide good adhesion to the metal layers. The ribbons may also be joined to the bus bars using conductive adhesives using temperatures of 200° C or less, preferably 150° C to 200° C. The methods avoid the higher and undesirable temperatures of conventional processes which require temperatures of 250° C to 350° C.

The methods eliminate sintering of metals to form silicides, thus reducing or eliminating shunting. Also reactivation of the metal underlayer prior to low internal stress copper plating is avoided. The overall number of metallization steps is reduced, thus making metallization of semiconductors more efficient and less costly than many conventional processes. Attachment of interconnect ribbons to bus bars on photovoltaic devices is done at lower temperatures than is typically done in conventional module assembly and may also be done using low melting point adhesives as opposed to soldering.

The following examples are included to illustrate the invention but are not intended to limit the scope of the invention.

### Examples 1

Two textured doped monocrystalline silicon wafers were provided. Each textured doped silicon wafer had an n+ doped zone on the front side of the wafer forming an emitter layer and a pn-junction below the emitter layer. The front side of each wafer was coated with an antireflective composite layer composed of silicon oxide/silicon nitride. The front side of each wafer had a pattern for current tracks through the antireflective layer which exposed the surface of the silicon wafers. The exposed silicon had a layer of native silicon dioxide. Each current track traversed the entire length of the wafer. The current tracks joined a bus bar at an end of each wafer and at the center of each wafer. The back side of each wafer was p+ doped and contained an aluminum electrode.

The monocrystalline wafers were then taped along their edges to a plating rack using 3M Circuit Plating Tape™ 1280. The tape prevented solution from contacting the back side aluminum electrode and protected the wafers from any potential undesired edge plating. Each wafer was then immersed in diluted (1%) hydrofluoric acid at room temperature for 1 minute to remove native silicon dioxide on the exposed silicon surfaces. The wafers were then immersed into an aqueous bath of ENGLIGHT™ 1400 Electrolytic Nickel plating solution contained in a chemically inert plating cell which was transparent to light. The aluminum electrodes on the backside of the wafers were in contact with the metal plating rack which was connected to a rectifier and a nickel electrode served as the anode. Plating temperature was 35° C. The current density was 2 A/dm². Artificial light was applied to the wafers throughout plating using a green LED light source. Nickel plating was done until a nickel layer 1µm thick was deposited on the silicon of the current tracks. The nickel layer on each wafer was then plated with a copper layer 10µm thick using the low internal stress electrolytic copper electroplating solution in Table 1 below.

**Table 1**

| **COMPONENT** | **AMOUNTS** |
|---|---|
| Copper oxide | 10 g/L |
| Sodium metabisulfite | 35 g/L |
| Dimethylhydantoin | 100 g/L |
| Potassium hydroxide | Buffered to pH 7.5-8.5 |

Artificial light was applied to the wafers throughout plating using a high intensity blue LED light source. The aluminum electrodes were connected to a rectifier and a copper electrode functioned as the anode. The solution was clear in color. The temperature of the solution was maintained at 30° C. The applied current density was 2 A/dm².

The wafers were then immersed in ENLIGHT™ Silver Plate 620 cyanide-free silver electroplating solution. The aluminum backside electrodes were connected to a rectifier and a soluble silver electrode functioned as the anode. The temperature of the electroplating solution was 35° C. The 250 watt incandescent lamp was the source of artificial light. The current density was 2 A/dm² and plating was done until a silver layer 2µm thick was deposited on the copper.

The wafers were removed from the electroplating solution and plating rack, blow dried by air, and observed for adhesion and electrical performance. The adhesion of the metal layers was tested using Scotch transparent tape Cat.# 600. The bond strength of the tape to the substrate was previously measured to be 1N using the GP Stab Test Pro. The tape was applied to the metal plated side of each wafer and then pulled from the wafer. The tape did not remove any metal on the wafers indicating that adhesion was higher than 1N. Cell performance was 16.9%, and 17.2%, respectively, as measured from flash test data collected from a QuickSun 120CA solar simulator manufactured by Endeas. None of the cells were shunted. The Rₛₕ for each cell was determined to be 150,000 ohm cm².

### Example 2 (comparative)

Two monocrystalline silicon wafers substantially the same as those used in Example 1 were prepared and nickel plated as described in Example 1. A copper electroplating solution was used to deposit a 10 µm thick high internal stress copper layer on the nickel. The high internal stress was determined to be as disclosed in Example 7 below. The formulation for the bath was that shown in Table 2 below.

**Table 2**

| **COMPONENT** | **AMOUNT** |
|---|---|
| Copper sulfate pentahydrate | 75 g/L |
| Sulfuric acid | 200 g/L |
| Chloride | 75 ppm |
| Bis-(sodium sulfopropyl)-disulfide | 2.5 ppm |
| Polyoxyethylene polyoxypropylene ether | 2 g/L |
| Water | Balance |

Artificial light was applied to the wafers throughout copper plating using a high intensity blue LED light source. The aluminum electrodes were connected to a rectifier and a copper electrode functioned as the anode. The copper bath was 25° C and the current density was 3 A/dm². The pH of the copper electroplating solution was less than 1.

The wafers were then immersed in ENLIGHT™ Silver Plate 620 cyanide-free silver electroplating solution. The aluminum backside electrodes were connected to a rectifier and a soluble silver electrode functioned as the anode. The temperature of the electroplating solution was 35° C. The 250 watt incandescent lamp was the source of artificial light. The current density was 2 A/dm² and plating was done until a silver layer 2µm thick was deposited in the copper.

The wafers were removed from the electroplating solution and plating rack, blow dried by air. Most of the plated metal was blown off during air drying, thus indicating poor metal adhesion. No cell electrical performance was tested due to the adhesion test failure.

### Example 3 (comparative)

Two textured doped monocrystalline silicon wafers were provided. Each textured doped silicon wafer had an n+ doped zone on the front side of the wafer forming an emitter layer and a pn-junction below the emitter layer. The front side of each wafer was coated with an antireflective composite layer composed of silicon oxide/silicon nitride. The front side of each wafer had a pattern for current tracks through the antireflective layer which exposed the surface of the silicon wafers. The exposed silicon had a layer of native silicon dioxide. Each current track traversed the entire length of the wafer. The current tracks joined a bus bar at an end of each wafer and at the center of each wafer. The back side of each wafer was p+ doped and contained an aluminum electrode.

The monocrystalline wafers were then taped along their edges to a plating rack using 3M Circuit Plating Tape™ 1280. The tape prevented solution from contacting the back side aluminum electrode and protected the wafers from any potential undesired edge plating. Each wafer was then immersed in diluted (1 %) hydrofluoric acid solution at room temperature for 1minute to remove native silicon dioxide on the exposed silicon surfaces. The wafers were then immersed into an aqueous bath of ENGLIGHT™ 1400 Electrolytic Nickel plating solution contained in a chemically inert plating cell which was transparent to light. The aluminum electrodes on the backside of the wafers were in contact with the metal plating rack which was connected to a rectifier and a nickel electrode served as the anode. Plating temperature was 35° C. The current density was 2 A/dm². Artificial light was applied to the wafers throughout plating using a green LED light source. Nickel plating was done until a nickel layer 150nm thick was deposited on the silicon of the current tracks.

Each plated wafer was removed from the plating rack and then placed in a Sierra Therm Furnace 7500 Series with T-3 Qz. IR lamps to sinter the wafers and form nickel silicide. The temperature in the furnace was ramped from room temperature to 425° C over 10 seconds with a peak setting sintering temperature of 425° C for a period of 10 seconds. The speed at which the wafers passed through the furnace was 150 cm/minute.

After cooling, the Rₛₕ of each wafer was measured using the Suns Voc tester. The Rₛₕ for the wafers were 48 ohm cm² and 190 ohm cm² indicative of significant shunting. The wafers were then taped along their edges to a plating rack using 3M Circuit Plating Tape™ 1280. The wafers were reactivated using 1% hydrofluoric acid for one minute. Each wafer was then plated with a 250nm nickel layer using ENLIGHT™ 1300 Electrolytic Nickel plating solution by the same method described above. The nickel layer on each wafer was then plated with a copper layer 10µm thick using the copper electroplating solution of Table 2 in Example 2. Artificial light was applied to the wafers throughout plating using a high intensity blue LED light source. The aluminum electrodes were in contact with the metal plating rack which was connected to a rectifier and a copper electrode functioned as the anode. The copper bath was 25° C and the current density was 3 A/dm². The wafers were then immersed in ENLIGHT™ Silver Plate 620 cyanide-free silver electroplating solution. The aluminum backside electrodes were in contact with the metal plating rack which was connected to a rectifier and a soluble silver electrode functioned as the anode. The temperature of the electroplating solution was 35° C. A 250 watt incandescent lamp was the source of artificial light. The current density was 2 A/dm² and plating was done until a silver layer 2µm thick was deposited in the copper.

The wafers were removed from the electroplating solution and plating rack, blow dried by air, and tested for adhesion and electrical performance. The adhesion of the metal layers was tested using Scotch transparent tape Cat.# 600. The tape was applied to the metal plated side of each wafer and then pulled from the wafer. The tape did not remove any metal on the wafers indicating that adhesion was higher than 1N. However, the cells electrical performance was 7.5%, and 12.7% as measured from flash test data collected from a QuickSun 120CA solar simulator and well below the electrical performance of the cells tested in Example 1 where the low internal stress copper bath was used and sintering was excluded.

### Example 4

Two textured doped monocrystalline silicon wafers were provided. Each textured doped silicon wafer had an n+ doped zone on the front side of the wafer forming an emitter layer and a pn-junction below the emitter layer. The front side of each wafer was coated with an antireflective composite layer composed of silicon oxide/silicon nitride. The front side of each wafer had a pattern for current tracks through the antireflective layer which exposed the surface of the silicon wafers. The exposed silicon had a layer of native silicon dioxide. Each current track traversed the entire length of the wafer. The current tracks joined a bus bar at an end of each wafer and at the center of each wafer. The back side of each wafer was p+ doped and contained an aluminum electrode.

The monocrystalline wafers were then taped along their edges to a plating rack using 3M Circuit Plating Tape™ 1280. The tape prevented solution from contacting the back side electrode and protected the wafers from any potential undesired edge plating. Each wafer was then immersed in diluted (1%) hydrofluoric acid solution at room temperature for 1 minute to remove native silicon dioxide on the exposed silicon surfaces. The wafers were then immersed into an aqueous bath of ENLIGHT™ 1400 Electrolytic Nickel plating solution contained in a chemically inert plating cell which was transparent to light. The aluminum electrodes on the back side of the wafers were in contact with the metal plating rack which was connected to a rectifier and a nickel electrode served as the anode. Plating temperature was 35° C. The current density was 2 A/dm². Artificial light was applied to the wafers throughout plating using a green LED light source. Nickel plating was done until a nickel layer 150nm thick was deposited on the silicon of the current tracks.

The nickel layer on each wafer was then plated with a copper layer 10µm thick using the low stress copper plating solution of Table 1 in Example 1. Artificial light was applied to the wafers throughout plating using a high intensity blue LED light source. The aluminum electrodes were in contact with the metal plating rack which was connected to a rectifier and a copper electrode functioned as the anode. The copper bath was 30° C and the current density was 2 A/dm². The wafers were then immersed in ENLIGHT™ Silver Plate 620 cyanide-free silver electroplating solution. The aluminum backside electrodes were connected to a rectifier and a soluble silver electrode functioned as the anode. The temperature of the electroplating solution was 35° C. A 250 watt incandescent lamp was the source of artificial light. The current density was 2 A/dm² and plating was done until a silver layer 2µm thick was deposited in the copper.

The wafers were removed from the electroplating solution and plating rack, blown dry by air, and tested for adhesion using a conductive adhesive/pull test. The conductive adhesive (from Engineered Conductive Materials, LLC) was applied to the bus bar of the plated cells by syringe. A 1.5mm wide interconnecting ribbon containing 66.5%Sn, 3.5%Ag (available from Luvata) was then pressed down on the bus bar and the cells with attached ribbon were then baked in a conventional convection oven for 10 minutes at 150° C. A pull test was performed using GP STAB-TEST PRO. The force determined to pull the metal layers from each wafer was 2N indicating that the metal layers were acceptable for many commercial applications.

### Example 5 (comparative)

Two wafers substantially the same as those used in Example 4 were processed in the same manner, except that a solder pull test was used to test adhesion of the plated metal. Solder flux was applied to a 1.5mm wide interconnecting ribbon containing 62%Sn, 36%Pb and 2%Ag (available from Indium Corporation of America). The wafer was heated to 70° C on an isotemp basic ceramic hotplate and the ribbon was soldered onto the busbar of the wafers using a Weller WDI soldering iron applied at 360° C. The soldered ribbons popped off when the wafers were transferred from the solder station to the pull tester. This indicated that the pull value was <1N after perform high temperature solder process.

### Example 6

The internal deposit stress of the copper plating solution of Table 1 in Example 1 was measured using the deposit stress analyzer. A flexible stress strip of copper/beryllium foil (available from Specialty Testing and Development Co., Jacobus, PA, www.specialtytest.com) was cut into two pieces and the weight of each piece was determined using a Ohaus EO2140 analytical balance. Each strip was coated on one side with a dielectric such that coating only occurs on the uncoated side. Coated sides were placed against a non-conductive laminate and the strips were held in place with plater's tape placed on the coated area that separates the "legs" of the strip from the conductive top base. The bottom of the legs was also held down to ensure that agitation did not bend the strips during plating. Copper tape was used on the top base to allow electrical contact. 3M Circuit Plating Tape™ 1280 was used to cover areas where plating was unwanted during the test. All tape is compressed down to prevent plating solution from getting under the tape. After mounting, the strips were cleaned using RonaClean PC-590 cleaner for 45 seconds followed by rinsing in deionized water for 30-60 seconds before being placed in the plating solution. The strips were then plated with copper for 10 minutes at 2 A/dm² to achieve a target deposition thickness of 5µm. After plating the strips were rinsed, removed from the laminate, air dried, and weighed. The difference in the weight of the strips before plating and after plating showed that the amount of copper deposited was 5µm thick. The strips were then taped onto a piece of copper cladding for support while measuring the strip deflection using the stress analyzer. The deposit stress was calculated to be 0 psi after plating and 0 psi after a 10 minute bake at 100° C, thus indicating low to no stress in the copper deposit.

### Example 7 (comparative)

The high internal stress copper plating bath of Table 2 was analyzed by the stress strip test. The stress strip was cut into two pieces and the weight of each piece was determined. The coated sides were placed against a non-conductive laminate and the strips were held in place with plater's tape placed on the coated area that separates the "legs" of the strip from the conductive top base. The bottom of the legs was also held down to ensure that agitation did not bend the strips during plating. Copper tape was used on the top base to allow electrical contact. 3M Circuit Plating Tape™ 1280 was used to cover any areas where plating was not desired during the test. All of the tape was compressed down to ensure that no plating solution seeped under the tape. After mounting, the strips were cleaned using RonaClean PC-590 cleaning solution for 45 seconds, then rinsed in deionized water for 30-60 seconds before being placed in the plating solution. The coupons were then plated with copper for 10 minutes at 2 A/dm² to achieve a target copper deposit of 5µm. After plating, the strips were rinsed with water, removed from the laminate, air dried, and weighed. The difference in weight of the strips before and after plating indicated that a copper deposit of 5µm thick was plated. The strips were then taped onto a piece of copper cladding for support for testing on the stress analyzer. The deposit stress was calculated to be 3653 psi after plating and 3155 psi after 10 minutes of baking at 100° C, thus indicating that the copper deposit had higher internal stress than the copper deposits of Example 6.

## Claims

1. A method consisting essentially of:
a) providing a semiconductor comprising a front side, a back side, and a pn-junction, the front side comprises a pattern of conductive tracks and a bus bar, the conductive tracks and the bus bar comprise an underlayer and the back side includes metal contacts;
b) contacting the semiconductor with a low internal stress copper plating composition; and
c) plating a low internal stress copper layer adjacent the underlayer of the conductive tracks and bus bar.

2. The method of claim 1, wherein the low internal stress copper is plated by electrolytic plating or light induced plating.

3. The method of claim 1, wherein the underlayer is chosen from nickel and cobalt.

4. The method of claim 1, further consisting essentially of attaching an interconnecting ribbon to the busbar at temperatures of 200° C or less.

5. The method of claim 4, wherein the temperature is 150° C to 200° C.

6. The method of claim 1, wherein the underlayer is 20nm to 2µm thick.

7. The method of claim 1, wherein the low stress copper layer is 1µm to 50µm thick.

8. The method of claim 1, further consisting essentially of depositing a metal flash layer or organic solderability preservative on the low stress copper layer.
